(19) Europäisches Patentamt
European Patent Office
Office européen des brevets

(11) **EP 2 418 676 A1**

(12) **EUROPEAN PATENT APPLICATION**

(43) Date of publication:
**15.02.2012 Bulletin 2012/07**

(51) Int Cl.:
**H01L 21/02** (2006.01)

(21) Application number: **11175466.9**

(22) Date of filing: **26.07.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **09.08.2010 JP 2010178928**

(71) Applicant: **Siltronic AG**
**81737 München (DE)**

(72) Inventors:
• **Deai, Hiroyuki**
**Yamaguchi 743-0005 (JP)**
• **Takayama, Seiji**
**Yamaguchi 743-0011 (JP)**

(74) Representative: **Staudacher, Wolfgang et al**
**Siltronic AG**
**Corporate Intellectual Property**
**Hanns-Seidel-Platz 4**
**81737 München (DE)**

(54) **Silicon wafer and production method thereof**

(57) To provide a silicon wafer comprising: a silicon substrate; a first epitaxial layer laid on one side of the silicon wafer, wherein the absolute value of the difference between the donor concentration and the acceptor concentration is set to equal or more than $1 \times 10^{18}$ atoms/cm$^3$; and a second epitaxial layer laid on the first epitaxial layer, whose conductivity type is the same as for said first epitaxial layer, wherein the absolute value of the difference between the donor concentration and the acceptor concentration is set to equal or less than $5 \times 10^{17}$ atoms/cm$^3$; wherein, by doping a lattice constant adjusting material into the first epitaxial layer, the variation amount $((a_1 - a_{Si})/ a_{Si})$ of the lattice constant of the first epitaxial layer $(a_1)$ relative to the lattice constant of the silicon single crystal $(a_{Si})$ as well as the variation amount $((a_2 - a_{Si}) / a_{Si})$ of the lattice constant of the second epitaxial layer $(a_2)$ relative to the lattice constant of the silicon single crystal $(a_{si})$ are controlled less than the critical lattice mismatches.

## FIG.1(A)

**Description**

Technical Field

The present invention relates to a technical field of silicon wafers used for semiconductor devices. Particularly, the present invention relates to a technology to prevent misfit dislocations that occur within silicon wafers that incorporate an epitaxial growth film.

Back Ground Art

Currently, silicon wafers used in semiconductor devices are required to have a denuded zone as well as a high gettering capability in a device active region on its surface layer.

As an example that satisfies those requirements, epitaxial wafers that use a highly doped substrate has been conventionally known.

An example of such wafers includes a p/p+ substrate. The p/p+ substrate is produced by a following method: producing a p+ substrate containing a boron concentration of roughly $5 \times 10^{19}$ atoms/cm$^3$ and subjecting the p+ substrate to mirror polishing as well as cleaning; then, epitaxially growing a 5 um thick device active layer on the mirror polished p+ substrate by the vapor phase epitaxy, wherein the device active layer is doped with a relatively low boron concentration of approximately $1 \times 10^{15}$ atoms/cm$^3$.

An n/n+ substrate is used for power MOSFET etc. The n/n+ substrate utilizes an n+ substrate which was highly doped with an n-type dopant such as phosphorus or arsenic. An n-type epitaxial layer which is doped with a relatively low phosphorus concentration of approximately $1 \times 10^{16}$ atoms/cm$^3$ is deposited on this n+ substrate to form the n/n+ substrate.

Also, IGBT often has a structure created by depositing a doped silicon layer with an n-type dopant on a p-type substrate, and further depositing a doped silicon layer with a low-concentration n-type phosphorus on the doped silicon layer with an n-type dopant.

The p-type substrate is doped with a high boron concentration. The doped silicon layer is a silicon layer doped with a high-concentration n-type dopant equal to or more than $1 \times 10^{17}$ atoms/cm$^3$ which is intended to stop expansion of the depletion layer.

The concentration of the upmost n-type lowly doped layer is controlled within the concentration from $1 \times 10^{13}$ atoms/cm$^3$ to $1 \times 10^{15}$ atoms/cm$^3$, depending on its gate oxide integrity.

The surface layer deposited by the epitaxial growth is defect-free. And heavy metals mixed in during device processes, in particular the Fe contamination, are strongly gettered. Since a yield ratio of devices can be improved, the epitaxial wafers using those highly doped substrates have been used widely for the semiconductor devices.

However, for the aforementioned wafers, misfit dislocations tend to occur at the interface between the substrate and the layer doped with a low concentration dopant, or at the interface between the low concentration epitaxial layer and the layer doped with a high concentration dopant, due to the variation in the lattice constant of a silicon crystal.

Such misfit dislocations may propagate through the device active layer depending on its form.

Taking a vertical power MOSFET as an example, dislocations penetrating through the device active layer (also called threading dislocation) may also penetrate both into the drain on the underside and the source on the surface. This would cause leak current between the source and the drain.

As for IGBT, there is a possibility of current leakage between the collector and the emitter. Such leak current may increase the power consumption of power devices on standby.

JP2004-175658 discloses a technology to prevent such misfit dislocations.

The invention of JP2004-175658 discloses a method in which a silicon epitaxial layer is deposited on a silicon substrate which is grown by doping at the same time a certain amount of boron and germanium to the silicon melt.

In this method, a certain amount of boron which shortens the lattice constant of a silicon crystal as well as germanium which lengthens the lattice constant of a silicon crystal is added to the silicon melt.

The effect of shortening the lattice constant by boron is offset by the effect of lengthening the lattice constant by germanium.

It is described that it is possible through this method to produce epitaxial silicon wafers in which the misfit dislocations are prevented.

JP2003-218031 describes another technology to prevent misfit dislocations.

JP2003-218031 discloses the following: SiC or GaN film is formed by epitaxially growing on the surface of an Si substrate; the zinc blend type single crystal of BP (boron phosphide) is used as a buffer layer during the growth; and, this enables to prevent the misfit dislocations caused by lattice mismatches.

More specifically, $BCl_3$ and $PCl_3$ as the raw materials for BP are introduced into a reaction tube after removing a native oxide film of an Si substrate. A low-temperature growth at approximately 200 - 500 °C is performed for 30 minutes.

Then the temperature is raised to 900 - 1200 °C, which is the temperature to grow a BP crystal, to grow a 1 to 5 $\mu$m thick BP film. Then, an SiC or GaN film is deposited on the top of the BP film by the epitaxial method. Also, it is described that the amount of warpage of the whole semiconductor wafers can be controlled by forming a film made of $SiO_2$ or $Si_3N_4$ in addition to the SiC or GaN film.

However, by the description of JP2003-218031, if a buffer layer is formed independently in order to prevent the misfit dislocations caused by lattice mismatches, a buffer layer does not function as a device.

Also, by the description of JP2004-175658, when forming a silicon substrate which is produced from a silicon melt doped with germanium as well as a high concentration of boron at the same time and depositing an epitaxial layer doped with a certain concentration of germanium and boron on this silicon substrate, the following problem may occur.

That is, if silicon substrates are produced from a growth crystal by the Czochralski method, the segregation of impurities such as a dopant arises as an unpreventable problem.

In addition, there is a large difference between the segregation coefficients of boron and germanium. Consequently, it is difficult to maintain a proper ratio of boron to germanium over the whole length of a crystal by the method described in JP2004-175658.

It has been difficult for all the substrates made of the crystal derived from such method to resolve the lattice mismatch between the substrate and the epitaxial layer.

Also, the expensive germanium must be consumed in large amount if the crystal growth such as the Czochralski method or the zone melting is used as in JP2004-175658.

Thus, the production costs for wafers increase.

The present invention has been completed as a result of intensive studies by the inventors in order to resolve the above problem.

The present invention provides a silicon wafer structure with reduced misfit dislocations and warpage.

The silicon wafer structure comprises a silicon substrate, the first epitaxial layer, and the second epitaxial layer. The silicon substrate exhibits resistivity of equal or more than 0.1 $\Omega \cdot$cm.

The first epitaxial layer has the absolute value of the difference between the donor concentration and the acceptor concentration of equal or more than $1 \times 10^{18}$ atoms/cm$^3$, and the first epitaxial layer is grown on one side of the silicon substrate's surface.

The second epitaxial layer has the absolute value of the difference between the donor concentration and the acceptor concentration of equal or less than $5 \times 10^{17}$ atoms/cm$^3$, and the second epitaxial layer is grown on one side of the first epitaxial layer's surface.

The second epitaxial layer has the same conductivity type as the first epitaxial layer.

A lattice constant adjusting material is added to the first epitaxial layer. Thereby, the variation amount ($(a_1-a_{si})$ / $a_{si}$) of the first epitaxial layer's lattice constant ($a_1$) relative to the silicon single crystal's lattice constant of ($a_{si}$) as well as the variation amount ( ($_a2 - a_{si}$) / $a_{si}$) of the second epitaxial layer's lattice constant ($a_2$) relative to the silicon single crystal's lattice constant of ($a_{si}$) can be controlled less than the critical lattice mismatch.

Effect of Invention

The present invention does not utilize a substrate which was highly doped and formed by the conventional Czochralski method or the zone melting. The doped silicon layer with a high-concentration impurity is totally formed by the epitaxial growth instead. The lattice constant can be controlled properly by doping the lattice constant adjusting material into this doped silicon layer with a high-concentration impurity.

Therefore, the lattice mismatch between a doped silicon layer with a low-concentration impurity and the interface can be cleared. The misfit dislocation or warpage can be also resolved.

In the present invention, the lattice constant adjusting material is doped in the epitaxial growth. Thus, the problem of the inhomogeneous concentration when doping a dopant (e.g. germanium, boron, etc.) in the conventional liquid phase growth can be prevented.

The present invention can be utilized for power MOSFET usages. The layer with a high dopant concentration has preferably a low resistivity to reduce ON resistance for the usage, and, the present invention can achieve even lower resistivity compared to a substrate with a high dopant concentration produced by the conventional liquid phase growth.

BRIEF DESCRIPTION OF THE DRAWINGS

Fig. 1A is a schematic view of the structure of the silicon wafer according to the present invention.
Fig. 1B is an enlarged schematic view of the interface between the epitaxial layer and the silicon substrate in the event of occurrence of misfit dislocations in the epitaxial wafer.

Fig. 2 is a schematic view of the structure of the silicon wafer according to the present invention.
Fig. 3 is a schematic view of the structures of POWERMOSFET and IGBT.

Detailed Description

The first aspect of the present invention is a wafer comprising a silicon substrate, the first epitaxial layer, and the second epitaxial layer.

The silicon substrate has the resistivity of equal or more than $0.1 \ \Omega \cdot cm$. The first epitaxial layer has the absolute value of the difference between the donor concentration and the acceptor concentration of equal or more than $1 \times 10^{18}$ atoms/cm3 .

The first epitaxial layer is grown on one side of the silicon substrate.

The second epitaxial layer has the absolute value of the difference between the donor concentration and the acceptor concentration of equal or to less than $5 \times 10^{17}$ atoms/cm$^3$.

The second epitaxial layer is grown on a surface of the first epitaxial layer.

The second epitaxial layer has the same conductivity type as the first epitaxial layer.

A lattice constant adjusting material is added to the first epitaxial layer.

Therefore, the variation amount ( $(a_1 - a_{si}) / a_{si}$ ) of the lattice constant of the first epitaxial layer ($a_1$) relative to the lattice constant of the silicon single crystal ($a_{si}$) as well as the variation amount ( $(_a2 - a_{si}) / a_{si}$ ) of the lattice constant of the second epitaxial layer ($a_2$) relative to the lattice constant of the silicon single crystal ($a_{si}$) are controlled less than the critical lattice mismatches.

Thereby, the problems of misfit dislocations or warpages can be resolved.

In the present invention, the lattice constant adjusting material is doped by the epitaxial growth.

Accordingly, the problem of a concentration inhomogeneity in doping a dopant (including a lattice constant adjusting material) in the conventional liquid phase growth can be prevented.

It is described in JP2006-080278 or JP2006-024728 that, in order to prevent the threading dislocation caused by the lattice mismatch, the silicon epitaxial layer which contains germanium as a lattice constant adjusting material is formed on the surface of the silicon substrate, and that the germanium concentration is reduced from the interface between the silicon substrate and the epitaxial layer gradually or in a stepwise manner.

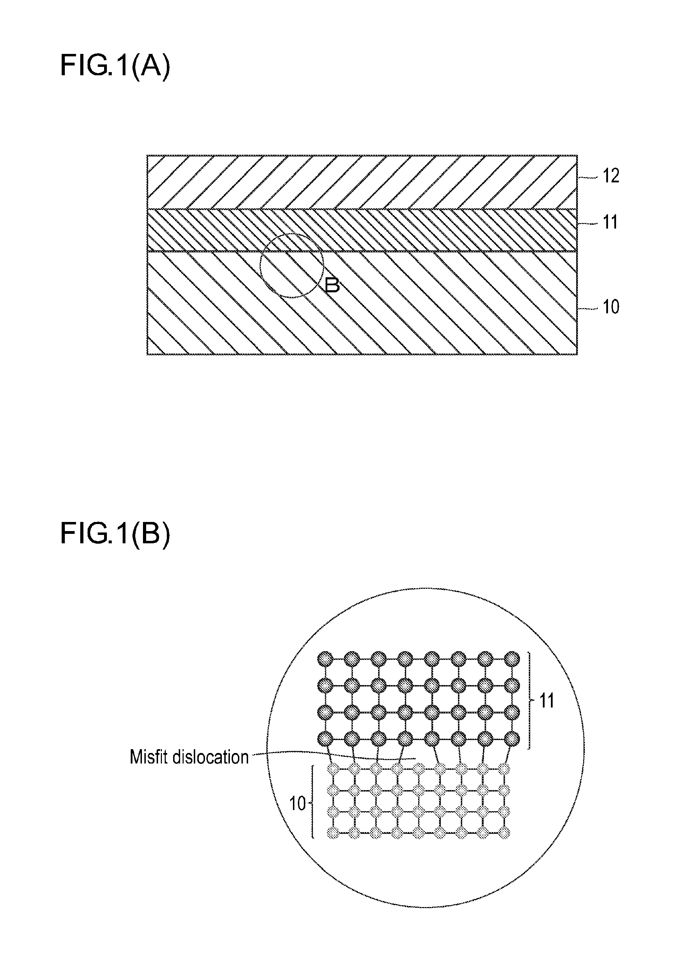

However, both of such methods can not prevent the misfit dislocation. As described in JP2006-86179, the misfit dislocation can occur even when the nitride films are placed between a plurality of the silicon epitaxial layers which include germanium whose concentration is varied gradually or in a stepwise manner (JP2006-86179, Fig. 1).

According to these methods in which the germanium concentration is varied gradually or in a stepwise manner, the germanium concentration can only be raised by 10% each time the silicon epitaxial layer containing germanium is grown in 1 $\mu$m thickness.

For example, in order to form an epitaxial layer with 30% germanium concentration, it is necessary to grow as thick as 3 $\mu$m. It takes almost 1 hour at the usual speed of forming an epitaxial layer (approximately 0.1 nm/s). Thus, the productivity is low.

However, the present invention properly controls the lattice constant of the epitaxial layer without varying the germanium concentration in a stepwise manner.

Therefore, the growth speed is not affected very much. Referring to the appended figures, the silicon wafers relevant to the present invention will be explained below.

Fig. 1 (A) is a schematic diagram showing an example of a semiconductor substrate according to a preferable embodiment of the present invention.

First, a silicon wafer relevant to the present invention has the following structure as shown in Fig. 1 (A).

A first epitaxial layer 11 (n-type or p-type) is grown on a silicon substrate (e.g. nondope, n-type or p-type silicon single crystal) 10 by the epitaxial growth method.

The first epitaxial layer 11 contains a lattice constant adjusting material as well as a donor and/or an acceptor.

A second eptaxial layer 12 which contains the same conductivity type of a donor and/or an acceptor as the first epitaxial layer is further grown on the first epitaxial layer by the epitaxial growth method.

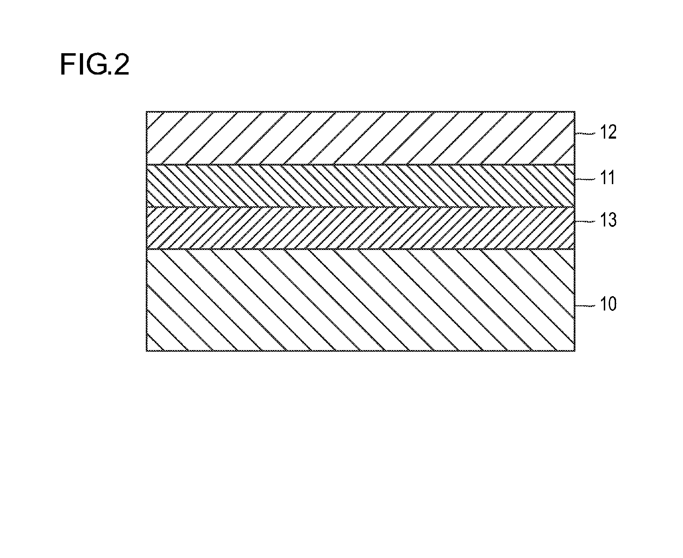

A third p-type epitaxial layer 13 containing a lattice constant adjusting material and a donor and/or an acceptor can be provided between the first epitaxial layer 11 and the silicon substrate 10 as described later referring to Fig. 2.

Referring to Fig. 1 (B), the interface between the silicon substrate 10 and the first epitaxial layer 11 will be explained as an example.

If there is a large difference in the lattice constants between the silicon substrate 10 and the first epitaxial layer 11, stress due to the misfit dislocations acts upon the first epitaxial layer.

As the epitaxial growth further continues, the variation amount of the lattice constant of the first epitaxial layer exceeds the critical level (also referred to as a critical lattice mismatch) (or the thickness of the first epitaxial layer 11 exceeds the critical film thickness).

This causes defects in the crystal such as lattice mismatches (misfit dislocations) that act as to relax the above-mentioned stress, as shown in Fig. 1 (B).

However, the growth of the epitaxial layer continues as long as the variation amount of the lattice constant of the first epitaxial layer does not exceed the critical level (that is, the thickness of the first epitaxial layer is thin enough).

Even though the lattice mismatch occurs insubstantially, the epitaxial layer grows since the continuity of the lattice is preserved at the interface due to the deformation of the lattice of the epitaxial layer (the coherent growth).

To explain in detail on the variation amount relevant to the present invention, the variation of the lattice constant can be expressed in Equation (1).

$$\Delta a / a = \beta \times N \qquad \text{Equation (1)}$$

wherein "a" is lattice constant, "$\Delta a$" is variation of the lattice constant, "N" is concentration of impurities(atom/ cm$^3$), "$\beta$" is proportionality coefficient (cm$^3$/atom), and "$\Delta a/a$" is lattice mismatch.

The lattice mismatch ($\Delta a / a$) as the variation amount of the lattice constant is proportional to the concentration of impurities N.

However, a proportionality coefficient $\beta$ differs depending on the impurities as described in Literature 1 (Literature 1: "Property of Crystalline Silicon", Inspec/Iee Jan. 2000, ISBN:0852969333).

According to this knowledge, if boron is used as an acceptor and phosphorus is used as a donor for example, the data shown in Table 1 has been known.

Table 1

| impurities | $\beta$ (cm$^3$/atom) |
|---|---|
| boron | $-5.46 \times 10^{24}$ |
| phosphorus | $-7.20 \times 10^{-25}$, $-1.00 \times 10^{-24}$, $-1.80 \times 10^{-24}$ |

As shown in the scheme with boron and phosphorus as a dopant, $\beta$ has a negative value and decreases the lattice constant.

That is, when a dopant such as a donor or an acceptor is doped and the atomic radius of the dopant (As, Ge, Sb, etc.) is greater than the atomic radius of silicon (1.17 Å) , the lattice constant of the silicon crystal which includes such dopant tends to increase.

On the other hand, if the atomic radius of a dopant (B, P) is smaller than the atomic radius of silicon (1.17Å) , then the lattice constant of the silicon crystal which includes such dopant tends to decrease.

These phenomena also occur in an epitaxial layer obtained by the epitaxial growth as well as in a silicon substrate doped with a dopant.

For this reason, it is necessary to increase the lattice constant of the silicon epitaxial layer in order to reduce the misfit dislocations when using an atomic element whose atomic radius is smaller than that of silicon (1.17Å) for the silicon epitaxial layer as an acceptor or a donor. In this case, an atomic element with a greater atomic radius than that of silicon is used as a lattice constant adjusting material.

On the other hand, when using an atomic element whose atomic radius is greater than that of silicon (1.17Å) for the silicon epitaxial layer as an acceptor or a donor, it is necessary to decrease the lattice constant of the silicon epitaxial layer.

An element with a smaller atomic radius than that of silicon (an element that reduces the lattice constant of silicon) is used as a lattice constant adjusting material in this case.

If the lattice constant adjusting material relevant to the present invention is used for increasing the lattice constant of silicon, the lattice constant adjusting material is preferably an atomic element whose atomic radius is greater than that of silicon and which does not change the resistance of the epitaxial layer (the first and the third). A compound containing germanium or tin is especially preferable.

A compound containing germanium is even more preferable.

If the lattice constant adjusting material relevant to the present invention is used for decreasing the lattice constant of silicon, the lattice constant adjusting material is preferably a material whose atomic radius is smaller than that of silicon and which does not change the resistance of the epitaxial layer (the first and third).

The epitaxial layer (the first and third) relevant to the present invention can be doped with arsenic instead of phosphorus. The $\beta$ Value for arsenic is not exactly known, but it is known to be very small. Thus, it is not necessary to dope germanium when doping arsenic.

When doping a lattice constant adjusting material relevant to the present invention, either an atomic element itself or a compound containing such atomic element can be doped alternatively.

Doping germanium is effective when utilizing boron as an acceptor for the silicon epitaxial layer and/or utilizing phosphorus as a donor.

Whereby, the effect of decreasing the lattice constant of silicon can be offset. Also, the lattice constant of germanium is greater by 4.2% than that of silicon. A simple approximation according to the Vegard's law teaches that $\beta_{Ge}$ is about $+8.4 \times 10^{-25}$ $cm^3$/atom, and that its absolute value is almost the same as that of phosphorus but with its sign reversed. By controlling the germanium concentration doped into the epitaxial layer relevant to the present invention, $\Delta a/a$ can be rendered closer to zero.

Here, the concentration of each donor in the silicon epitaxial layer is defined as $[X]_{Dk}$, its $\beta$ Value as $\beta_{Dk}$, the concentration of each acceptor as $[X]_{Ak}$, its $\beta$ Value as $\beta_{Ak}$, the $\beta$ Value of the lattice constant adjusting material as $\beta_Y$, the concentration of the lattice constant adjusting material as $[Y]$. By controlling according to Equation 2 below, the degree of lattice mismatch ($\Delta a/a$) within the system disappears and the misfit dislocation does not occur.

$$\beta_Y \times [Y] + \sum \beta_{Dk} \times [X]_{Dk} + \sum \beta_{Ak} \times [X]_{Ak} = 0 \qquad \text{Equation (2)}$$

One of either phosphorus or boron is used as a donor or an acceptor for example.

The concentration of boron or phosphorus is defined as $[X]$, its $\beta$ Value as $\beta x$, the concentration of germanium as $[Ge]$, its $\beta$ value as $\beta_{Ge}$. It should be preferably controlled according to the value indicated in Equation (2-2) below.

$$\beta_{Ge} \times [Ge] + \beta_x \times [X] = 0 \qquad \text{Equation (2-2)}$$

On the other hand, the lattice of the epitaxial layer can be deformed in case of the coherent growth as stated above if the epitaxial layer is thin enough. Therefore, the occurrence of misfit dislocations also depends on the thickness of layers. The detail is described in Literature 2 ("J. W. Matthews, A. E. Blakeslee [J. Cryst. Growth (Netherlands) vol. 27 (1974) p.118; vol. 29 (1975) p.273; vol. 32 (1976) p.265").

That is, the misfit dislocation may not occur even though Equations (2) or (2-2) is not satisfied if the layer is thin. According to the inventors' findings, it was confirmed that the misfit dislocation does not occur if Equation (3) is satisfied.

$$\beta_Y \times [Y] + \sum \beta_{Dk} \times [X]_{Dk} + \sum \beta_{Ak} \times [X]_{Ak} < \gamma \qquad \text{Equation (3)}$$

wherein "$\gamma$" is dimensionless number which is called as critical lattice mismatches ( or critical distortion).

$\beta_Y \times [Y]$ is the value $\Delta a_y/a_{si}$ which is obtained by dividing the variation of the lattice constant ($\Delta a_y$) in doping a lattice constant adjusting material into the silicon single crystal by the lattice constant ($a_{si}$) of the silicon single crystal in Equation (3) above.

$\beta_{Dk} \times [X]_{Dk}$ is the value $\Delta a_{Dk}/a_{si}$ which is obtained by dividing the variation of the lattice constant ($\Delta a_{Dk}$) in doping various donors into the silicon single crystal by the lattice constant ($a_{si}$) of the silicon single crystal likewise.

$\beta_{Ak} \times [X]_{Ak}$ is the value $\Delta a_{Ak}/a_{si}$ which is obtained by dividing the variation of the lattice constant ($\Delta a_{Ak}$) in doping various acceptors into the silicon single crystal by the lattice constant ($a_{si}$) of the silicon single crystal.

Therefore, the left side of Equation (3) is obtained by dividing the sum of the variations of the lattice constants in doping the silicon single crystal with the lattice constant adjusting material, each donor, and each acceptor individually by the lattice constant of the silicon single crystal.

On the other hand, when doping the lattice constant adjusting material, each donor, and each acceptor into the silicon epitaxial layer at the same time, the variation of the lattice constant can be obtained by summing up the variations of the lattice constant, which are caused by doping the lattice constant adjusting material, each donor, and each acceptor individually into the silicon single crystal.

Therefore, it is understood that the variation of the lattice constant in the first epitaxial layer relevant to the present invention, which is $\Delta a_{1-si}$ ($= a_1 - a_{si}$) , is equal to the left side of the above Equation (3) multiplied by the lattice constant of the silicon single crystal for example.

The variation of the lattice constant of the second and third epitaxial layers relevant to the present invention can be considered likewise.

When either phosphorus or boron is used as a door or an acceptor and germanium is used as a lattice constant adjusting material as in the above Equation (2-2), the following Equation (3-2) results.

$$\beta_{Ge} \times [Ge] + \beta_x \times [X] < \gamma \qquad \text{Equation (3-2)}$$

wherein "$\gamma$" is dimensionless number which is called as critical lattice mismatches( or critical distortion).

The $\gamma$ in the above equation is a function of the layer thickness of the epitaxial layer.

By measuring $\gamma$ corresponding to a thickness in advance, a proper value can be obtained at ease. According to the inventors' findings, $\gamma$ can be described by the following Equation (4) with T ($\mu$m) being the thickness of the epitaxial layer.

$$Log(\gamma) = -1.11 \times Log(T) - 3.84 \qquad \text{Equation (4)}$$

in this regard, wherein "Log" is common logarithm.

The preferable embodiments of the present invention will be explained below referring to figures.

Fig. 2 is a schematic cross-section diagram showing an example of a semiconductor substrate according to another preferable embodiment of the present invention.

First, a silicon wafer relevant to the present invention can be formed by the following process as shown in Fig. 2. A third p-type epitaxial layer 13 which contains a lattice constant adjusting material as well as a donor and/or an acceptor is grown on a silicon substrate (e.g. nondope, n-type or p-type silicon single crystal) 10 by the epitaxial growth method.

Next, a first n-type epitaxial layer 11 which contains a lattice constant adjusting material as well as a donor and/or an acceptor is grown on the third epitaxial layer 13 by the epitaxial growth method.

A second epitaxial layer 12 which contains a donor and/or an acceptor with the same conductivity type as the first epitaxial layer 11 is grown on the first epitaxial layer 11.

Heat treatment can be alternatively performed after depositing the third epitaxial layer, the first epitaxial layer, and the second epitaxial layer on the silicon substrate, respectively, as stated above.

The silicon substrate relevant to the present invention is not particularly limited anyhow as far as its resistivity is equal or more than 0.1 $\Omega$·cm.

The resistivity is preferably within 1 $\Omega$·cm to 100 $\Omega$·cm.

The silicon substrate production method relevant to the present invention can be performed by a public known method such as the Czochralski method or the FZ method.

It would not matter if the silicon substrate is produced by oneself or obtained as a commercialized product or if it is n-type or p-type.

The silicon substrate relevant to the present invention may utilize a silicon crystal which contains hydrogen, nitrogen, and carbon.

The method of doping nitrogen, hydrogen, or carbon into a silicon crystal (or a silicon substrate formed by cutting out a grown silicon crystal) is not particularly limited anyhow. Any conventional method can be used. More specifically, as a method of doping nitrogen, by adding silicon substrates with a nitride film into a melt in which a silicon crystal is grown, the nitrogen concentration for the silicon substrate to be obtained can be controlled.

The hydrogen concentration can be controlled as a method of doping hydrogen by injecting a hydrogen mixed gas to a furnace.

The carbon concentration of the silicon substrate wafer can be controlled as a method of doping carbon by doping carbon powders into the melt in which the silicon crystal is grown.

The first epitaxial layer relevant to the present invention is preferably a silicon epitaxial layer doped with a dopant and a lattice constant adjusting material. The first epitaxial layer contains silicon as a main ingredient. The first epitaxial layer comprises the followings: at least one substance selected from a group consisting of donor elements as a dopant (an element in the group 13 such as boron, or any known dopant containing a such element) and acceptor elements (an element in the group 15 such as phosphorus or arsenic, or any known dopant containing a such element); and a lattice constant adjusting material.

If both a donor and an acceptor are contained as a dopant, it is preferred that the absolute value of the difference between the donor concentration and the acceptor concentration is equal or more than $1 \times 10^{18}$ atoms/cm$^3$ and equal or less than $1 \times 10^{20}$ atoms/cm$^3$.

The same concentration range is applied when either a donor or an acceptor is contained in the first epitaxial layer.

In addition, the composition ratio of the above-described constituents for the first epitaxial layer is controlled according to the above Equation (3).

The thickness of the first epitaxial layer is preferably not more than 10 $\mu$m, or more preferably not less than 1 $\mu$m and not more than 5 $\mu$m.

If its thickness is equal or less than 10 $\mu$m, the misfit dislocation can be suppressed or prevented since it is less than the critical thickness of an epitaxial layer.

The second epitaxial layer relevant to the present invention is preferably a silicon epitaxial layer doped with a dopant. The second epitaxial layer contains silicon as a major component.

The second epitaxial layer comprises the followings: at least one substance selected from a group consisting of donor elements as a dopant (an element in the group 13 such as boron, or any known dopant containing a such element) and acceptor elements (an element in the group 15 such as phosphorus and arsenic, or any known dopant containing a such element).

If both a donor and an acceptor are contained as a dopant, it is preferred that the absolute value of the difference between the donor concentration and the acceptor concentration is equal or less than $5 \times 10^{17}$ atoms/cm$^3$.

The same concentration range is applied when either a donor or an acceptor is contained.

In addition, the composition ratio of the above-described constituents for the second epitaxial layer is controlled according to the above Equation (3).

The third epitaxial layer relevant to the present invention is preferably a silicon epitaxial layer doped with an acceptor and a lattice constant adjusting material.

The third epitaxial layer contains silicon as a major component. The third epitaxial layer contains, as an acceptor, an element in the group 13 such as boron, or any known dopant containing a such element, as well as a lattice constant adjusting material.

If both a donor and acceptor are included as a dopant, it is preferred that the absolute value of the difference between the donor concentration and the acceptor concentration is equal or more than $1 \times 10^{18}$ atoms/cm$^3$ and equal or less than $1 \times 10^{20}$ atoms/cm$^3$.

The same concentration range is applied when either a donor or an acceptor is contained.

In addition, the composition ratio of the above-described constituents for the third epitaxial layer is controlled according to the above Equation (3).

The thickness of the third epitaxial layer is preferably not more than 20 $\mu$m, or more preferably not less than 1 $\mu$m and not more than 10 $\mu$m.

If its thickness is equal or less than 20 $\mu$m, it is less than the critical film thickness, and thus the misfit dislocation can be suppressed and prevented.

The first, the second, and the third epitaxial layers relevant to the present invention can be fabricated by means of CVD (Chemical Vapor Deposition) or MBE (Molecular Beam Epitaxy).

There is no restriction on the method by which those layers are fabricated.

If a CVD process is chosen for example, any known source gas can be used. The choice of a source gas is not limited.

A source gas can be any of the followings: $SiHCl_3$, $SiH_4$, $SiH_2Cl_2$, etc. for the silicon element; $B_2H_6$ etc. for the boron element if boron is used as an acceptor; $PH_3$ etc. for the phosphorus element if phosphorus is used as an acceptor; $GeH_4$, $GeCl_4$, etc. if germanium is used as a lattice constant adjusting material; or any mixed gas.

$H_2$ can be used as a carrier gas. The growth condition is not specifically limited and can be chosen arbitrarily. The temperature 700 - 1100 °C and the pressure 100 Pa to the normal pressure can suitably be used as an embodiment.

Examples of the preferable embodiments of the silicon wafer relevant to the present invention will be explained hereafter.

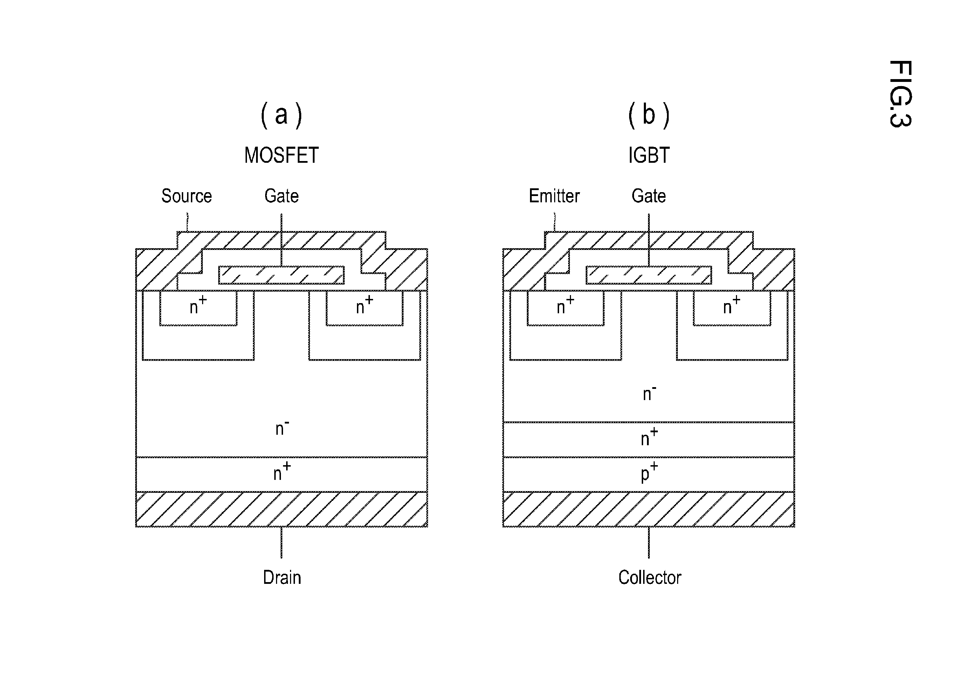

A case in which a wafer relevant to the present invention is applied to an n-type or a p-type power MOSFET as shown in Fig. 3(A) will be explained below as an example.

A silicon wafer is produced by the Czochralski method for example as described above. This wafer should preferably have the resistivity of equal or more than 0.1 $\Omega \cdot$cm and could be n-type, p-type, or nondope. That is, for the epitaxial layer used as a drift layer of a power MOSFET, the lattice mismatch should be low enough not to cause any trouble. According to the findings of the inventors, it was confirmed that the misfit dislocations can be successfully prevented and the warpage does not worsen when the variation ratio of the lattice constant, $( (a_1 - a_{si}) / a_{si} )$, is controlled less than about $1 \times 10^{-5}$.

A first epitaxial layer highly doped with a dopant (a donor and/or an acceptor) is subsequently formed on the silicon substrate.

This epitaxial layer is a layer corresponding to a drain electrode.

Thus, an impurity or a dopant is doped with the concentration of equal or more than $1 \times 10^{19}$ atoms/cm$^3$ in many cases. Therefore, the lattice constant is varied compared to when a silicon substrate, especially nondope silicon substrate, is used.

After the first epitaxial layer was formed, a second epitaxial layer doped in a low concentration is formed. This second epitaxial layer contains a relatively low impurity concentration since it is used for the drift layer of a power device.

The concentration of an impurity or a dopant is generally equal or less than $5 \times 10^{17}$ atoms/cm$^3$, and the variation in the lattice constant is negligible. It is not necessary to dope a lattice constant adjusting material such as germanium in contrast to a highly doped layer such as the first epitaxial layer.

A case in which a wafer relevant to the present invention is applied to a punch through IGBT as shown in Fig. 3(B) will be explained as an example hereafter.

A silicon substrate is produced as described above, thereafter, a p-type third epitaxial layer into which boron is doped with the concentration not less than $1 \times 10^{18}$ atoms/cm$^3$ and not more than $1 \times 10^{20}$ atoms/cm3 is formed.

This layer corresponds to a collector of an IGBT. Then, an n-type first epitaxial layer into which phosphorus or arsenic is doped with the concentration not less than $1 \times 10^{17}$ atoms/cm$^3$ and not more than $1 \times 10^{19}$ atoms/cm$^3$ is formed. This layer corresponds to a field stop layer of a depletion layer.

The above-described p-type or n-type, highly doped layer may possibly be prone to misfit dislocations, depending on its concentration.

A lattice constant adjusting material such as germanium is doped into the first and the third epitaxial layer in accordance with the above Equation (3) if necessary.

An n-type layer (the second epitaxial layer) into which phosphorus or arsenic is further doped with the concentration not less than $1 \times 10^{13}$ atoms/cm$^3$ and not more than $1 \times 10^{15}$ atoms/cm$^3$ is formed.

This n-type layer corresponds to a base of a bipolar. This n-type layer is generally lowly doped as described above, and thus it is not necessary to dope a lattice constant adjusting material such as germanium.

Examples

Examples of the present invention will be explained hereafter. However, the present invention is not limited to below-mentioned Examples. That is, Examples mentioned below are meant to be exemplary only. Anything having substantially the same configuration as the technical spirit described in the claims of the present invention and anything having the similar function effect are considered to be within the technical range of the present invention.

Example 1

Mirror wafers were produced by slicing n-type, Czochralski-grown silicon single crystal ingot with a diameter of 200 mm and a phosphorus concentration of $5 \times 10^{14}$ atoms/cm$^3$ and by subjecting the sliced wafers to a wafer production process. After that, the wafers were set in a single-loading type device for growing epitaxial vapor-phase in a lamp-heating method, and subjected to a 1100 °C hydrogen atmosphere for heat treatment to be cleaned.

Then, a mixed reactant gas of SiHCl$_3$, GeCl$_4$, and PH$_3$ was supplied under the condition with 1050 °C and a normal pressure. A first epitaxial layer with the donor concentration (phosphorus concentration) of $7 \times 10^{19}$ atoms/cm$^3$ as well as a lattice constant adjusting material (germanium concentration) of $9 \times 10^{19}$ atoms/cm$^3$ was grown in 10 $\mu$m thickness on the wafer through the CVD process.

The germanium concentration and the phosphorus concentration of the first epitaxial layer were implemented by SIMS (Secondary Ion Mass Spectroscopy).

In order to control the germanium concentration and the phosphorus concentration for the first epitaxial layer, the concentration of PH$_3$ gas or GeCl$_4$ gas can be altered, or their flows can be altered alternatively. It took 5 minutes to grow the first epitaxial layer of 10 $\mu$m thick.

Next, a second epitaxial layer with the donor concentration (phosphorus concentration) of $1 \times 10^{14}$ atoms/cm$^3$ was grown on the first epitaxial layer in 50 $\mu$m thickness through the CVD process under the condition with 1150 °C and a normal pressure. It took 20 minutes for this growing process.

After growing the epitaxial layers, the above-mentioned wafer was subjected to heat treatment in an Argon atmosphere with 1100 °C for 1 hour.

The occurrence of misfit dislocations in the resulted wafer was investigated using an X-ray topography device, then, it was confirmed that there was no occurrence of misfit dislocations.

Example 2

Mirror wafers were produced by slicing n-type, Czochralski-grown silicon single crystal ingot with a diameter of 200 mm and a phosphorus concentration of $5 \times 10^{14}$ atoms/cm$^3$ and by subjecting the sliced wafers to a wafer production process. After that, the wafers were set in a single-loading type device for growing epitaxial vapor-phase in a lamp-heating method, and subjected to a 1100 °C hydrogen atmosphere for heat treatment.

Then, a mixed reactant gas of SiHCl$_3$, GeCl$_4$, and B$_2$H$_6$ was supplied under the condition with 1050 °C and a normal pressure. A third epitaxial layer (p-type) with the acceptor concentration (boron concentration) of $5 \times 10^{19}$ atoms/cm$^3$ as well as a lattice constant adjusting material (germanium concentration) of $3.3 \times 10^{20}$ atoms/cm$^3$ was grown in 10 $\mu$m thickness on the wafer through the CVD process.

In order to control the germanium concentration and the boron concentration for the third epitaxial layer, the concentration of B$_2$H$_6$ gas or GeCl$_4$ gas can be altered, or their flows can be altered alternatively.

It took 5 minutes to grow the 10 $\mu$m thick, third epitaxial layer.

Then, a mixed reactant gas of SiHCl$_3$, GeCl$_4$, and PH$_3$ was supplied under the condition with 1150 °C and a normal pressure. A first epitaxial layer with the donor concentration (phosphorus concentration) of $1 \times 10^{19}$ atoms/cm$^3$ as well as a lattice constant adjusting material (germanium concentration) of $1 \times 10^{19}$ atoms/cm$^3$ was grown in 10 $\mu$m thickness on the third epitaxial layer through the CVD process. It took 5 minutes for this growing process.

Then, a mixed reactant gas of SiHCl$_3$ and PH$_3$ was supplied under the condition with 1150 °C and a normal pressure. A second epitaxial layer with the donor concentration (phosphorus concentration) of $1 \times 10^{14}$ atoms/cm$^3$ was grown in 50 $\mu$m thickness on the first epitaxial layer through the CVD process. It took 20 minutes for this growing process.

After growing the epitaxial layers, the above-mentioned wafer was subjected to heat treatment in an Argon atmosphere with 1100 °C for 1 hour.

The occurrence of misfit dislocations in the resulted wafer was investigated using the X-ray topography device, then, it was confirmed that there was no occurrence of misfit dislocations.

Comparative Example 1

Mirror wafers were produced by slicing n-type, Czochralski-grown silicon single crystal ingot with a diameter of 200 mm and a phosphorus concentration of $5 \times 10^{14}$ atoms/cm$^3$ and by subjecting the sliced wafers to a wafer production process. After that, the wafers were set in the leaf-like, lamp-heated epitaxial vapor-phase growth device and subjected to a 1100 °C hydrogen atmosphere for heat treatment.

Then, a mixed reactant gas of SiHCl$_3$ and PH$_3$ was supplied under the condition with 1150 °C and a normal pressure. A highly doped epitaxial layer with the donor concentration (phosphorus concentration) of $7 \times 10^{19}$ atoms/cm$^3$ was grown in 10 $\mu$m thickness on the wafer through the CVD process. The concentration of this highly doped epitaxial layer was implemented by the SIMS as described above.

Next, a lowly doped layer with the donor concentration (phosphorus concentration) of $1 \times 10^{14}$ atoms/cm$^3$ was grown on the above highly doped epitaxial layer in 50 $\mu$m thickness through the CVD process under the condition with 1150 °C and a normal pressure. It took 20 minutes for this growing process.

After growing the epitaxial layers, the above wafer was subjected to heat treatment in an Argon atmosphere with 1100 °C for 1 hour.

The occurrence of misfit dislocations in the resulted wafer was investigated using the X-ray topography device, it was confirmed that there was an occurrence of misfit dislocations almost all over the wafer.

Comparative Example 2

Mirror wafers were produced by slicing n-type, Czochralski-grown silicon single crystal ingot with a diameter of 200 mm and a phosphorus concentration of $5 \times 10^{14}$ atoms/cm$^3$ and by subjecting the sliced wafers to a wafer production process. After that, the wafers were set in the leaf-like, lamp-heated epitaxial vapor-phase growth device and subjected to a 1100 °C hydrogen atmosphere for heat treatment.

Then, a mixed reactant gas of SiHCl$_3$ and B$_2$H$_6$ was supplied under the condition with 1150 °C and a normal pressure. A p-type highly doped epitaxial layer with the acceptor concentration (boron concentration) of $5 \times 10^{19}$ atoms/cm$^3$ was grown in 10 $\mu$m thickness on the wafer through the CVD process.

In order to control the germanium concentration and the boron concentration for the p-type highly doped epitaxial layer, the concentration of B$_2$H$_6$ gas or GeCl$_4$ gas can be altered, or their flows can be altered alternatively. Also, it took 5 minutes to grow the 10 $\mu$m thick, p-type highly doped epitaxial layer.

Then, a mixed reactant gas of SiHCl$_3$ and PH$_3$ was supplied under the condition with 1150 °C and a normal pressure. An n-type highly doped epitaxial layer with the donor concentration (phosphorus concentration) of $1 \times 10^{19}$ atoms/cm$^3$ was grown in 10 $\mu$m thickness on the p-type highly doped epitaxial layer through the CVD process. It took 5 minutes for this growing process.

Then, a mixed reactant gas of SiHCl$_3$, and PH$_3$ was supplied under the condition with 1150 °C and a normal pressure. A lowly doped epitaxial layer with the donor concentration (phosphorus concentration) of $1 \times 10^{14}$ atoms/cm$^3$ was grown in 50 $\mu$m thickness on the n-type highly doped epitaxial layer through the CVD process. It took 20 minutes for this growing process.

After growing the epitaxial layers, the above-mentioned wafer was subjected to heat treatment in an Argon atmosphere with 1100 °C for 1 hour.

The occurrence of misfit dislocations in the resulted wafer was investigated using the X-ray topography device, then, it was confirmed that there was an occurrence of misfit dislocations almost all over the wafer.

The data on the resistivity of Examples and Comparative Examples and the variation amount of the lattice constants of each epitaxial layer are summarized in Table 2 below.

Table 2

| | SR ($\Omega$cm) | Dif 1 (atoms/cm$^3$) | $((a_1-a_{S1})/a_{S1})$ | Dif 2 (atoms/cm$^3$) | $((a_2-a_{S1})/a_{S1})$ | Dif 3 (atoms/cm$^3$) | $((a_3-a_{S1})/a_{S1})$ |
|---|---|---|---|---|---|---|---|
| Ex. 1 | 8.8 | $7.00\times10^{19}$ | $-9.96\times10^{-6}$ | $1.00\times10^{14}$ | $-1.20\times10^{-10}$ | | |
| Ex. 2 | 8.8 | $1.00\times10^{19}$ | $8.20\times10^{-6}$ | $1.00\times10^{14}$ | $-1.20\times10^{-10}$ | $5.00\times10^{19}$ | $-2.4\times10^{-6}$ |
| Comp. Ex. 1 | 8.8 | $7.00\times10^{19}$ | $-8.40\times10^{-5}$ | $1.00\times10^{14}$ | $-1.20\times10^{-10}$ | | |
| Comp. Ex. 2 | 8.8 | $5.00\times10^{19}$ | $-2.73\times10^{-4}$ | $1.00\times10^{14}$ | $-1.20\times10^{-10}$ | $1.00\times10^{19}$ | |

SR: substrate resistivity
Dif **1:** Absolute value of difference between donor concentration and acceptor concentration in the first epitaxial layer $((a_1-a_{Sl})/a_{Sl})$: Variation amount of lattice constant in the first epitaxial layer Dif 2: Absolute value of difference between donor concentration and acceptor concentration in the second epitaxial layer
$((a_2-a_{Sl})/a_{Sl})$: Variation amount of lattice constant in the second epitaxial layer Dif 3: Absolute value of difference between donor concentration and acceptor concentration in the third epitaxial layer
$((a_3-a_{Sl})/a_{Sl})$: Variation amount of lattice constant in the third epitaxial layer

**Claims**

1. A silicon wafer comprising:

   a silicon substrate having a resistivity of equal or more than 0.1$\Omega\cdot$cm;
   the first epitaxial layer provided on one side of said silicon wafer, wherein an absolute value of difference between a donor concentration and an acceptor concentration is equal or more than $1\times10^{18}$ atoms/cm$^3$; and
   the second epitaxial layer provided on said first epitaxial layer, said second epitaxial layer having a same conductivity type as said first epitaxial layer, wherein an absolute value of difference between a donor concentration and an acceptor concentration is equal or less than $5\times10^{17}$ atoms/cm$^3$;
   wherein, by doping a lattice constant adjusting material into said first epitaxial layer, a variation amount $((a_1 - a_{si}) / a_{si})$ of a lattice constant of said first epitaxial layer $(a_1)$ relative to a lattice constant of a silicon single crystal $(a_{si})$ and a variation amount $((a_2 - a_{si}) / a_{si})$ of a lattice constant of said second epitaxial layer $(a_2)$ relative to the lattice constant of the silicon single crystal $(a_{si})$ are controlled less than a critical lattice mismatches.

2. The silicon wafer of Claim 1, wherein
   said critical lattice mismatches is expressed by Equation (4) below:

$$Log(\gamma) = -1.11 \times Log(T) - 3.84 \qquad \texttt{equation (4)}$$

   where $\gamma$ is said critical lattice mismatches and T is a thickness of the first or second epitaxial layer.

3. The silicon wafer of Claims 1 or 2, wherein said lattice constant adjusting material is a compound containing germanium.

4. The silicon wafer of any one of Claims 1 to 3, further comprising the p-type third epitaxial layer between said first epitaxial layer and said silicon substrate, with an acceptor concentration of said third epitaxial layer being $1\times10^{18}$ atoms/cm$^3$, wherein said conductivity type of said first and second epitaxial layers is n-type,

and wherein, by doping said lattice constant adjusting material into said first and third epitaxial layers, a variation amount $((a_3 - a_{Si}) / a_{Si})$ of a lattice constant of said third epitaxial layer $(a_3)$ relative to the lattice constant of the silicon single crystal $(a_{Si})$ are controlled less than the critical lattice mismatches.

# FIG.1(A)

# FIG.1(B)

Misfit dislocation

FIG.2

FIG.3

(a)
MOSFET

Source
Gate

n+
n+

n-
n+

Drain

(b)
IGBT

Emitter
Gate

n+
n+

n-
n+
p+

Collector

EP 2 418 676 A1

Europäisches
Patentamt

European
Patent Office

Office européen
des brevets

# EUROPEAN SEARCH REPORT

Application Number

EP 11 17 5466

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RAJENDRAN: "Measurement and Simulation of Boron Diffusion Strained Si1-xGex Epitaxial Layers", IEEE TRANSACTIONS ON ELECTRON DEVICES, vol. 48, no. 9, 1 January 2001 (2001-01-01), page 2022, XP55012954, ISSN: 0018-9383, DOI: 10.1109/16.944192 * pages 2022-2023, chapter 'II. Experimental Technique' * * pages 2024-2025, chapter 'III.A Strain in Si1-xGex' * * page 2029, Appendix * * figures 1, 2 * * table 1 * ----- | 1-4 | INV. H01L21/02 |
| X | JP 2005 079134 A (TOSHIBA CERAMICS CO) 24 March 2005 (2005-03-24) * paragraph [0010] - paragraph [0011] * * paragraph [0031] - paragraph [0032] * * figure 1 * ----- | 1,2 | |
| X | US 5 261 999 A (PINKER RONALD D [US] ET AL) 16 November 1993 (1993-11-16) * column 1, line 65 - column 2, line 6 * * column 2, line 41 - column 3, line 34 * ----- | 1-3 | TECHNICAL FIELDS SEARCHED (IPC) H01L |
| A | KIM ET AL: "Temperature-dependent critical layer thickness for strained-layer heterostructures", APPLIED PHYSICS LETTERS, AIP, AMERICAN INSTITUTE OF PHYSICS, MELVILLE, NY, US, vol. 67, no. 15, 9 October 1995 (1995-10-09), pages 2212-2214, XP012013766, ISSN: 0003-6951, DOI: 10.1063/1.115106 * the whole document * ----- -/-- | 1,2 | |

The present search report has been drawn up for all claims

| Place of search | Date of completion of the search | Examiner |
|---|---|---|
| Munich | 28 November 2011 | Bruckmayer, Manfred |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 11 17 5466

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 2003 209059 A (SUMITOMO MITSUBISHI SILICON) 25 July 2003 (2003-07-25) * the whole document * ----- | 1-3 | |
| A | US 2005/176262 A1 (ONO TOSHIAKI [JP] ET AL) 11 August 2005 (2005-08-11) * paragraph [0014] - paragraph [0020] * ----- | 1-3 | |

TECHNICAL FIELDS
SEARCHED     (IPC)

The present search report has been drawn up for all claims

| Place of search | Date of completion of the search | Examiner |
|---|---|---|
| Munich | 28 November 2011 | Bruckmayer, Manfred |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.......................................................................................

& : member of the same patent family, corresponding
    document

EPO FORM 1503 03.82 (P04C01)

EP 2 418 676 A1

## ANNEX TO THE EUROPEAN SEARCH REPORT
## ON EUROPEAN PATENT APPLICATION NO.

EP 11 17 5466

This annex lists the patent family members relating to the patent documents cited in the above-mentioned European search report.
The members are as contained in the European Patent Office EDP file on
The European Patent Office is in no way liable for these particulars which are merely given for the purpose of information.

28-11-2011

| Patent document cited in search report | | Publication date | Patent family member(s) | | Publication date |
|---|---|---|---|---|---|
| JP 2005079134 | A | 24-03-2005 | NONE | | |
| US 5261999 | A | 16-11-1993 | NONE | | |
| JP 2003209059 | A | 25-07-2003 | JP 4165073 B2 | | 15-10-2008 |
| | | | JP 2003209059 A | | 25-07-2003 |
| US 2005176262 | A1 | 11-08-2005 | JP 4590876 B2 | | 01-12-2010 |
| | | | JP 2005223092 A | | 18-08-2005 |
| | | | US 2005176262 A1 | | 11-08-2005 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004175658 A
- JP 2003218031 A
- JP 2006080278 A
- JP 2006024728 A
- JP 2006086179 A

### Non-patent literature cited in the description

- Property of Crystalline Silicon. *Inspec/Iee,* January 2000, ISBN 0852969333
- **J. W. MATTHEWS ; A. E. BLAKESLEE.** *J. Cryst. Growth (Netherlands,* 1974, vol. 27, 118
- *J. CRYST. GROTH ( NETHERLANDS,* 1975, vol. 29, 273
- *J. CRYST. GROTH ( NETHERLANDS,* 1976, vol. 32, 265